Europäisches Patentamt

European Patent Office

Office européen des brevets

(19)

(11) **EP 0 823 057 B1**

(12) **EUROPÄISCHE PATENTSCHRIFT**

(45) Veröffentlichungstag und Bekanntmachung des Hinweises auf die Patenterteilung:
**29.09.1999  Patentblatt 1999/39**

(51) Int Cl.⁶: **G01R 27/16**, G01R 29/16, G01R 31/08, H02H 9/08, H02J 3/26

(21) Anmeldenummer: **96910847.1**

(22) Anmeldetag: **24.04.1996**

(86) Internationale Anmeldenummer:
**PCT/AT96/00081**

(87) Internationale Veröffentlichungsnummer:
**WO 96/34293 (31.10.1996 Gazette 1996/48)**

(54) **VERFAHREN ZUM ÜBERWACHEN EINES DREHSTROMNETZES AUF EINE ABSTIMMUNGSÄNDERUNG DER ERDSCHLUSSLÖSCHSPULE**

PROCESS FOR MONITORING A THREE-PHASE MAINS FOR A CHANGE IN THE TUNING OF THE ARC SUPRESSION COIL

PROCEDE PERMETTANT DE CONTROLER UNE VARIATION DE SYNTONISATION DE LA BOBINE D'EXTINCTION DANS UN RESEAU TRIPHASE

(84) Benannte Vertragsstaaten:
**AT DE FI FR IT SE**

(30) Priorität: **25.04.1995  AT 70495**

(43) Veröffentlichungstag der Anmeldung:
**11.02.1998  Patentblatt 1998/07**

(73) Patentinhaber: **Trench Austria GmbH
4060 Leonding (AT)**

(72) Erfinder:
• **PAPP, Klaus
A-4040 Linz (AT)**
• **DRUML, Gernot
A-4203 Altenberg (AT)**

(74) Vertreter: **Weiser, Andreas, Dip.-Ing. et al
Patentanwälte Schütz u.Partner,
Schottenring 16,
Börsegebäude
1010 Wien (AT)**

(56) Entgegenhaltungen:
EP-A- 0 595 677    EP-B- 0 235 145
CH-A- 155 905      DE-A- 2 426 871
DE-A- 2 735 756    DE-A- 2 849 083
DE-A- 4 329 382

**Beschreibung**

Die vorliegende Erfindung betrifft ein Verfahren zum Überwachen eines Drehstromnetzes auf eine Abstimmungsänderung der Erdschlußlöschspule, wobei die an der Erdschlußlöschspule auftretende Sternpunkt-Verlagerungsspannung kontinuierlich gemessen und mit einem Toleranzbereich verglichen wird und ein Verlassen des Toleranzbereiches eine Abstimmungsänderung anzeigt.

Derartige Verfahren sind bekannt und nützen die Tatsache aus, daß bei realen Drehstromnetzen stets eine gewisse Unsymmetrie der einzelnen Phasen vorliegt, so daß im Sternpunkt, d.h. an der Erdschlußlöschspule, eine bestimmte Sternpunkt-Verlagerungsspannung auftritt, welche bei Resonanzabstimmung der Erdschlußlöschspule ein Maximum hat und eine Resonanzkurve beschreibt. Eine Änderung der Abstimmung der Erdschlußlöschspule kann daher an einer Änderung der Sternpunkt-Verlagerungsspannung erkannt werden.

Moderne Drehstromnetze sind in zunehmendem Maße phasensymmetrisch, nicht zuletzt wegen des zunehmenden Überganges von Freileitungssystemen auf Kabelsysteme, so daß die Verlagerungsspannungen immer kleiner werden und signifikante Änderungen der Verlagerungsspannung nicht mehr meßbar sind. Beispielsweise stellt sich beim Zuschalten eines symmetrischen Leitungsabschnittes keine Änderung der Verlagerungsspannung ein, so daß eine derartige Änderung des Schaltzustandes bzw. der Netzkonfiguration nicht erkannt werden kann. Anderseits erfolgt durch das Zuschalten des symmetrischen Leitungsabschnittes eine Erhöhung der Erdkapazität des Netzes, so daß der Resonanzkreis aus Erdschlußlöschspule und Erdkapazität an sich verstimmt ist, ohne daß dies im fehlerfreien Normalbetrieb erkennbar ist.

Um auch bei weitgehend symmetrischen Drehstromnetzen eine Verstimmung der Erdschlußlöschspule bereits im fehlerfreien Netzbetrieb erkennen zu können, wurden verschiedene Maßnahmen vorgeschlagen, die alle darauf beruhen, eine künstliche Unsymmetrie in das Netz einzuführen. Beispielsweise kann eine der Phasen des Netzes an der Sammelschiene mit einem Widerstand, einer Induktivität, einem Kondensator oder einer Stromeinspeisung beschaltet werden, oder es werden bereits beim Aufbauen des Netzes unterschiedliche Kabellängen je Phase verlegt. Diese Lösungen sind nicht nur aufwendig, sondern es kann die eingeführte künstliche Unsymmetrie bei bestimmten Schaltzuständen in gemischten Netzen sich mit anderen künstlichen oder natürlichen Unsymmetrien wieder aufheben.

Aus der EP-A-0 595 677 ist ein Verfahren bekannt, mit welchem die Verstimmung einer Erdschlußlöschspule zu einem bestimmten Zeitpunkt gemessen werden kann, u.zw. durch Beaufschlagen der Erdschlußlöschspule mit einem Hilfssignal, wobei die Verstimmung aus der durch diese Beaufschlagung hervorgerufenen Änderung der Sternpunkt-Verlagerungsspannung im Vergleich zu der eingespeisten Beaufschlagung ermittelt wird. Als Hilfssignal wird ein Hilfsstrom in den Sternpunkt eingespeist. Obwohl dieses Verfahren keine vorhandene Sternpunkt-Verlagerungsspannung voraussetzt und daher auch bei symmetrischen Netzen anwendbar ist, ermöglicht es nur eine zeitlich punktuelle, momentane Messung des Verstimmungsgrades der Erdschlußlöschspule; eine kontinuierliche Überwachung der Abstimmung ist nicht möglich. Zwar könnte mit diesem Verfahren die Abstimmung in bestimmten Zeitabständen, z.B. periodisch, gemessen werden, doch bleibt das Problem, daß eine Verstimmung der Erdschlußlöschspule damit erst nach einiger Zeit entdeckt wird, d.h. das Netz ist jeweils über längere Zeitspannen nicht abgestimmt.

Die Erfindung setzt sich zum Ziel, ein Verfahren zum Überwachen eines Drehstromnetzes auf eine Abstimmungsänderung der Erdschlußlöschspule zu schaffen, das auch bei symmetrischen Netzen anwendbar ist, die Symmetrie des Netzes selbst nicht beeinträchtigt und die unverzügliche Erkennung einer Änderung der Abstimmung ermöglicht, so daß umgehend Gegenmaßnahmen ergriffen werden können. Dieses Ziel wird mit einem Verfahren der einleitend genannten Art erreicht, das sich erfindungsgemäß dadurch auszeichnet, daß die Erdschlußlöschspule kontinuierlich mit einem Hilfssignal beaufschlagt wird, um eine Erhöhung der Sternpunkt-Verlagerungsspannung hervorzurufen.

Dadurch wird es erstmals auch bei symmetrischen Netzen möglich, die Sternpunkt-Verlagerungsspannung als Meßgröße heranzuziehen, was eine fortlaufende Überwachung ermöglicht. Die Beaufschlagung der Erdschlußlöschspule, d.h. Signaleinspeisung in den Sternpunkt, wird dadurch zum ersten Mal für die laufende Netzüberwachung eingesetzt, was einen völlig neuen Lösungsansatz in Abkehr von den oben geschilderten Verfahren darstellt.

Eine bevorzugte Alternative des erfindungsgemäßen Verfahrens besteht darin, daß die Sternpunkt-Verlagerungsspannung kontinuierlich mit einem vorgebbaren unteren Schwellwert verglichen wird, unter dem Änderungen der Sternpunkt-Verlagerungsspannung nicht mehr mit ausreichender Empfindlichkeit gemessen werden können, und daß bei einem Unterschreiten des Schwellwertes die Erdschlußlöschspule kontinuierlich mit einem Hilfssignal beaufschlagt wird, um eine Erhöhung der Sternpunkt-Verlagerungsspannung hervorzurufen. Auf diese Weise kann die Einspeisung auf jene Zeiten beschränkt werden, in welchen keine ausreichende Verlagerungsspannung für die Überwachung zur Verfügung steht.

Wenn mit dem erfindungsgemäßen Verfahren eine Veränderung der Abstimmung der Erdschlußlöschspule erkannt worden ist, kann die anschließende Abstimmung der Erdschlußlöschspule auf Resonanz oder einen vorgewählten Kompensationsgrad an sich mit jedem bekannten Abstimmverfahren durchgeführt werden, beispielsweise mittels Durchstimmen der Erdschlußlöschspule auf das Maximum der Verlagerungsspannung. Das erfindungsgemäße Überwachungsverfahren eignet sich jedoch insbesondere für eine Verbindung mit dem aus der EP-A-0 595 677 bekannten Verfahren zur Bestimmung des momentanen Verstimmungsgrades der Erdschlußlöschspule, weil für dieses Verfahren die Teile jener konstruktiven Einrichtungen mitverwendet können, die für das erfindungsgemäße Verfahren eingesetzt werden. Gemäß einer besonders vorteilhaften Variante der Erfindung wird daher vorgesehen, daß im Falle des Erkennens einer Abstimmungsänderung das eingespeiste Hilfssignal in Betrag und/oder Phase diskret oder kontinuierlich verändert wird, um eine Änderung der Verlagerungsspannung hervorzurufen, aus welcher die Verstimmung der Erdschlußlöschspule in an sich bekannter Weise an Hand eines komplexen Vergleiches der Änderung der Sternpunkt-Verlagerungsspannung mit der Änderung des Hilfssignales ermittelt wird, woraufhin die Erdschlußlöschspule auf Grundlage der ermittelten Verstimmung auf den vorgewählten Kompensationsgrad eingestellt wird.

In diesem Fall ist es besonders günstig, wenn die Änderung des eingespeisten Hilfssignales, welche für das Verfahren zur Ermittlung der Verstimmung durchgeführt werden muß, durch ein einfaches Umpolen des Hilfssignales erfolgt.

Das Beaufschlagen der Erdschlußlöschspule mit dem Hilfssignal kann auf jede dem Fachmann bekannte Art erfolgen, beispielsweise auf alle in der EP-A-0 595 677 beschriebenen Varianten. Besonders bevorzugt erfolgt die Beaufschlagung durch direktes Einspeisen eines Hilfsstromes in den Sternpunkt des Drehstromnetzes, oder durch Einspeisen eines Hilfsstromes in eine Leistungshilfswicklung der Erdschlußlöschspule.

Die Erfindung wird nachstehend an Hand eines in den Zeichnungen dargestellten Ausführungsbeispieles näher erläutert. In den Zeichnungen zeigt

Fig. 1 das vereinfachte Ersatzschaltbild eines mit einer Erdschlußlöschspule betriebenen Drehstromsystems in Verbindung mit einer Anordnung zur Durchführung des erfindungsgemäßen Verfahrens,
Fig. 2 die nach dem Verfahren der Symmetrischen Komponenten ermittelte Ersatzschaltbilddarstellung des Nullsystems des Drehstromnetzes von Fig. 1,
Fig. 3 die Resonanzkurve der Sternpunkt-Verlagerungsspannung über der Sternpunkt-Admittanz und
Fig. 4 den Ortskreis der Sternpunkt-Verlagerungsspannung bezüglich der Sternpunkt-Admittanz.

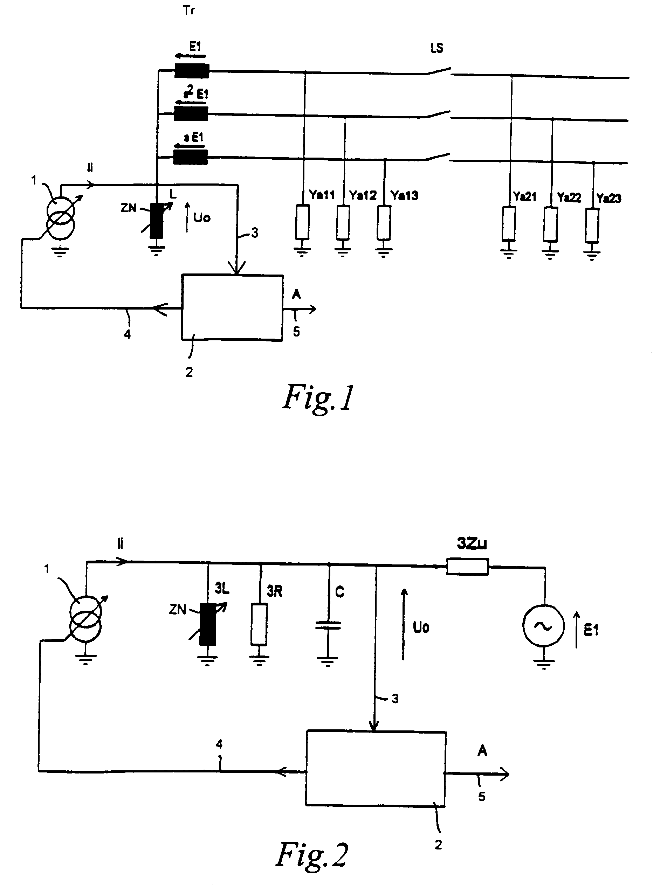

Das in Fig. 1 dargestellte Drehstromnetz umfaßt einen Transformator Tr, welcher die drei Phasenspannungen $E1$, $a^2E1$ und $aE1$ in den drei Phasen erzeugt, wobei $a = -0,5+j\sqrt{3}$) ist. Die Leitungskapazitäten und -leitwerte der drei Phasen gegen Erde sind durch die Admittanzen $Y_{a11}$, $Y_{a12}$ und $Y_{a13}$ dargestellt. Das Zuschalten eines weiteren Leitungsabschnittes mit den Admittanzen $Y_{a21}$, $Y_{a22}$ und $Y_{a23}$ ist mit Hilfe eines Schutzes LS möglich.

Der Sternpunkt des Drehstromnetzes ist über eine Erdschlußlöschspule ZN (Petersen-Spule) der Induktivität L geerdet. Die Anordnung zur Durchführung des erfindungsgemäßen Verfahrens umfaßt eine den Sternpunkt des Netzes speisende Hilfsstromquelle 1 und eine Steuereinrichtung 2, welche einen Meßwert der Sternpunkt-Verlagerungsspannung $U_o$ empfängt und später beschrieben wird.

Durch Anwendung des Verfahrens der Symmetrischen Komponenten kann aus dem Ersatzschaltbild von Fig. 1 das Symmetrische Komponentenersatzschaltbild für das Nullsystem gemäß Fig. 2 aufgestellt werden. Das Ersatzschaltbild für das Nullsystem zeigt, daß sich eine Unsymmetrie der Erdadmittanzen $Y_{a11}$, $Y_{a12}$, $Y_{a13}$ als Innenimpedanz $3Zu$ einer Spannungsquelle $E1$ auswirkt, die einen Parallelschwingkreis aus Erdschlußlöschspule $3L$, Summe der ohmschen Ableitungen der Phasen gegen Erde $3R$ und Ersatzkapazität $C$ für die Erdkapazitäten der drei Phasen speist.

Bei stark symmetrischen Netzen ist die Innenimpedanz $3Zu$ sehr hoch ($3Zu>>$), so daß die an der Erdschlußlöschspule auftretende Nullpunkt-Verlagerungsspannung $U_o$ sehr klein wird und Änderungen derselben nicht mehr signifikant meßbar sind. Wird beispielsweise der Schaltzustand des Drehstromnetzes geändert, z.B. durch Schließen des Schalters LS, ändert sich die Kapazität $C$ des Schwingkreises von Fig. 2 und die Erdschlußlöschspule ist nicht mehr abgestimmt. Wenn der zugeschaltete Leitungsabschnitt weitgehend symmetrisch ist ($Y_{a21}=Y_{a22}=Y_{a23}$), tritt dabei keine nennenswerte Änderung der Sternpunkt-Verlagerungsspannung $U_o$ auf. Die folgende Anordnung und Verfahrensweise ermöglichen nun auch unter diesen Betriebsbedingungen die ständige Erzeugung eines Anzeigekriteriums für eine Änderung der Verstimmung des Erdschlußlöschkreises.

Zu diesem Zweck wird die Erdschlußlöschspule ZN mit einem Hilfssignal beaufschlagt, um eine Speisung des Parallelresonanzkreises zu erzielen, so daß an der Erdschlußlöschspule eine Sternpunkt-Verlagerungsspannung $U_o$ abfällt, welche auf eine Änderung überwacht werden kann. Das Hilfssignal hat bevorzugt Netzfrequenz, was allerdings für den bloßen Zweck der Erkennung einer Änderung des Resonanzkreises nicht zwingend ist. Die Verwendung eines netzfrequenten Hilfssignales hat jedoch den Vorteil, daß die überwachte Resonanzkurve der Resonanzkurve im Fehlerfall entspricht.

Die Beaufschlagung der Erdschlußlöschspule ZN mit dem Hilfssignal kann auf jede beliebige, dem Fachmann bekannte Art erfolgen. Einige Varianten sind in der EP-A-0 595 677 beschrieben, wie das Einspeisen eines Hilfsstromes in eine Leistungshilfswicklung der Erdschlußlöschspule, was den Vorteil hat, daß die einspeisende Stromquelle nur für die Niederspannungsseite dimensioniert werden muß. Die Einspeisung erfolgt wie dargestellt durch direktes Anschalten der Stromquelle 1 an den Sternpunkt, so daß diesem ein Hilfsstrom $I_i$ zugeführt wird. Als Stromquelle 1 kann eine steuerbare Stromquelle verwendet werden, deren Betrag und Winkel kontinuierlich oder in diskreten Schritten einstellbar sind.

Die Erdschlußlöschspule ZN kann permanent mit einem Hilfssignal beaufschlagt werden. Eine Alternative besteht darin, das Hilfssignal nur dann einzuspeisen, wenn die Sternpunkt-Verlagerungsspannung unter einen vorgebbaren Schwellwert fällt, welcher vorzugsweise die Meßgrenze darstellt, unter der Änderungen der Sternpunkt-Verlagerungsspannung nicht mehr signifikant gemessen bzw. erkannt werden können. Die Steuereinrichtung 2 überwacht daher die Sternpunkt-Verlagerungsspannung $U_o$ auf einem Meßpfad 3 und schaltet bei einem Unterschreiten des Schwellwertes die Stromquelle 1 über einen Steuerpfad 4 ein.

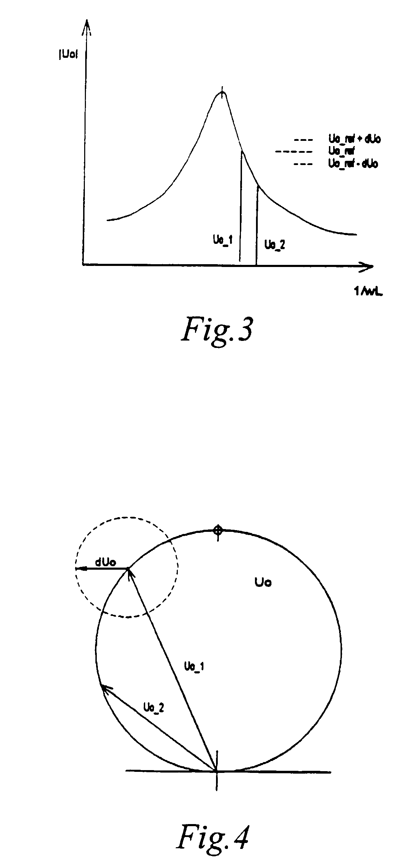

Die Steuereinrichtung 2 führt auch die Überwachung der Sternpunkt-Verlagerungsspannung $U_o$ im hinblick auf eine signifikante Änderung durch und gibt auf einem Ausgabepfad 5 ein Anzeigesignal A aus, wenn eine derartige Änderung auftritt. Das Kriterium zur Erzeugung des Anzeigesignales A wird an Hand der Diagramme der Fig. 3 und 4 beschrieben, welche zwei Alternativen zeigen.

Bei der Variante gemäß Fig. 3 wird festgestellt, ob der Betrag der Verlagerungsspannung $|U_o|$ einen Toleranzbereich verläßt, der durch einen oberen Grenzwert $U_{o\_ref}+dU_o$ und einen unteren Grenzwert $U_{o\_ref}-dU_o$ bestimmt wird, d.h.

$$A = (|U_o| > |U_{o\_ref}+dU_o|) \text{ ODER } (|U_o| < |U_{o\_ref}-dU_o|)$$

Bei der Variante gemäß Fig. 4 wird die Verlagerungsspannung $U_o$ vektoriell nach Betrag und Phase gemessen und das Verlassen eines Toleranzkreises mit dem Radius $dU_o$ angezeigt, d.h.

$$A = |U_o - U_{o\_ref}| > |dU_o|$$

Sobald eine den Toleranzbereich überschreitende Änderung der Sternpunkt-Verlagerungsspannung erkannt worden ist, können Maßnahmen veranlaßt werden, um eine Neuabstimmung der Erdschlußlöschspule vorzunehmen. Dies kann an sich mit Hilfe jedes dem Fachmann bekannten Verfahrens durchgeführt werden, sei es manueller oder automatischer Natur; im einfachsten Fall wird die Erdschlußlöschspule per Hand auf das Maximum der Sternpunkt-Verlagerungsspannung oder auf den gewünschten Kompensationsgrad eingestellt.

Das vorgeschlagene Überwachungsverfahren eignet sich insbesondere für eine Verbindung mit dem aus der EP-A-0 595 677 bekannten Meßverfahren zur Ermittlung der momentanen Verstimmung der Erschlußlöschspule. Anstelle des für dieses Meßverfahren notwendigen vorübergehenden Einspeisens eines Hilfssignales wird das für das gegenständliche Überwachungsverfahren bereits eingespeiste Hilfssignal in seinem Betrag und/oder seiner Phase diskret oder kontinuierlich verändert, um die Verstimmungsmessung durchzuführen. Im einfachsten Fall wird das eingespeiste Hilfssignal vorübergehend abgeschaltet, bevorzugt wird es aber lediglich umgepolt, d.h. in seiner Phase um 180° gedreht. Nach Ermittlung der Verstimmung kann die Erdschlußlöschspule in dem durch die Verstimmung angegebenen Ausmaß auf Abstimmung oder den gewünschten Kompensationsgrad zurückgestellt werden.

Der gesamte Ablauf des offenbarten Überwachungsverfahrens sowie der gegebenenfalls anschließenden Verstimmungsmessung und Neueinstellung der Erdschlußlöschspule kann manuell oder mittels eines entsprechend programmierten Rechners automatisch durchgeführt werden.

**Patentansprüche**

1.  Verfahren zum Überwachen eines Drehstromnetzes auf eine Abstimmungsänderung der Erdschlußlöschspule (ZN), wobei die an der Erdschlußlöschspule auftretende Sternpunkt-Verlagerungsspannung ($U_o$) kontinuierlich gemessen und mit einem Toleranzbereich verglichen wird und ein Verlassen des Toleranzbereiches eine Abstimmungsänderung anzeigt, dadurch gekennzeichnet, daß die Erdschlußlöschspule (ZN) kontinuierlich mit einem Hilfssignal ($I_i$) beaufschlagt wird, um eine Erhöhung der Sternpunkt-Verlagerungsspannung ($U_o$) hervorzurufen.

2.  Verfahren zum Überwachen eines Drehstromnetzes auf eine Abstimmungsänderung der Erdschlußlöschspule, wobei die an der Erdschlußlöschspule auftretende Sternpunkt-Verlagerungsspannung kontinuierlich gemessen und mit einem Toleranzbereich verglichen wird und ein Verlassen des Toleranzbereiches eine Abstimmungsänderung anzeigt, dadurch gekennzeichnet, daß die Sternpunkt-Verlagerungsspannung ($U_o$) kontinuierlich mit einem vorgebbaren unteren Schwellwert verglichen wird, unter dem Änderungen der Sternpunkt-Verlagerungsspannung nicht mehr mit ausreichender Empfindlichkeit gemessen werden können, und daß bei einem Unterschreiten des Schwellwertes die Erdschlußlöschspule (ZN) kontinuierlich mit einem Hilfssignal ($I_i$) beaufschlagt wird, um eine Erhöhung der Sternpunkt-Verlagerungs-

spannung ($U_o$) hervorrufen.

3. Verfahren nach Anspruch 1 oder 2, zusätzlich zur manuellen oder automatischen Abstimmung der Erdschlußlöschspule auf einen vorgewählten Kompensationsgrad, dadurch gekennzeichnet, daß im Falle des Erkennens einer Abstimmungsänderung das eingespeiste Hilfssignal ($I_i$) in Betrag und/oder Phase diskret oder kontinuierlich verändert wird, um eine Änderung der Verlagerungsspannung ($U_o$) hervorzurufen, aus welcher die Verstimmung der Erdschlußlöschspule (ZN) in an sich bekannter Weise anhand eines komplexen Vergleiches der Änderung der Sternpunkt-Verlagerungsspannung mit der Änderung des Hilfssignales ermittelt wird, woraufhin die Erdschlußlöschspule auf Grundlage der ermittelten Verstimmung auf den vorgewählten Kompensationsgrad eingestellt wird.

4. Verfahren nach Anspruch 3, dadurch gekennzeichnet, daß das Hilfsignal ($I_i$) durch Umpolen in seiner Phase verändert wird.

5. Verfahren nach einem der Ansprüche 1 bis 4, dadurch gekennzeichnet, daß die Beaufschlagung der Erdschlußlöschspule (ZN) mit dem Hilfsignal ($I_i$) durch direktes Einspeisen eines Hilfsstromes in den Sternpunkt des Drehstromnetzes erfolgt.

6. Verfahren nach einem der Ansprüche 1 bis 4, dadurch gekennzeichnet, daß die Beaufschlagung der Erdschlußlöschspule (ZN) mit dem Hilfsignal ($I_i$) durch Einspeisen eines Hilfsstromes in eine Leistungshilfswicklung der Erdschlußlöschspule erfolgt.

**Claims**

1. Method for monitoring a three-phase network for a change in tuning of the arc suppression coil (ZN), wherein the neutral displacement voltage ($U_o$) occurring at the arc suppression coil is measured continuously and compared with a tolerance range and a departure from the tolerance range indicates a change in tuning, characterised in that the arc suppression coil (ZN) is continuously subjected to an auxiliary signal ($I_i$) in order to bring about an increase in the neutral displacement voltage ($U_o$).

2. Method for monitoring a three-phase network for a change in tuning of the arc suppression coil, wherein the neutral displacement voltage occurring at the arc suppression coil is measured continuously and compared with a tolerance range and a departure from the tolerance range indicates a change in tuning, characterised in that the neutral displacement voltage ($U_o$) is continuously compared with a presettable lower threshold value below which changes in the neutral displacement voltage can no longer be measured with sufficient sensitivity, and in that on falling below the threshold value the arc suppression coil (ZN) is continuously subjected to an auxiliary signal ($I_i$) in order to bring about an increase in the neutral displacement voltage ($U_o$).

3. Method according to claim 1 or 2, in addition to manual or automatic tuning of the arc suppression coil to a preselected degree of compensation, characterised in that, in case of detection of a change in tuning, the auxiliary signal ($I_i$) supplied is discretely or continuously altered in amount and/or phase in order to bring about a change in the displacement voltage ($U_o$) from which the detuning of the arc suppression coil (ZN) is determined in a manner known in the art with the aid of a complex comparison of the change in neutral displacement voltage with the change of auxiliary signal, whereupon the arc suppression coil is adjusted to the preselected degree of compensation on the basis of the measured detuning.

4. Method according to claim 3, characterised in that the auxiliary signal ($I_i$) is altered in phase by reversing polarity.

5. Method according to any of claims 1 to 4, characterised in that the arc suppression coil (ZN) is subjected to the auxiliary signal ($I_i$) by direct supply of an auxiliary current to the neutral point of the three-phase network.

6. Method according to any of claims 1 to 4, characterised in that the arc suppression coil (ZN) is subjected to the auxiliary signal ($I_i$) by supply of an auxiliary current to a power auxiliary winding of the arc suppression coil.

**Revendications**

1. Procédé pour contrôler une modification d'accord de la bobine d'extinction d'arc (ZN) d'un réseau triphasé, selon lequel la tension de décalage ($U_o$) du neutre, qui apparaît dans la bobine d'extinction d'arc, est mesurée de façon continue et est comparée à une plage de tolérances, et le fait que cette tension quitte la plage de tolérances indique une modification d'accord, caractérisé en ce que la bobine d'extinction d'arc (ZN) est chargée continûment par un signal auxiliaire ($I_i$) servant à provoquer un accroissement de la tension de décalage ($U_o$) du neutre.

2. Procédé pour contrôler une modification d'accord de la bobine d'extinction d'arc (ZN) d'un réseau triphasé, selon lequel la tension de décalage ($U_o$) du neutre, qui apparaît dans la bobine d'extinction d'arc, est mesurée de façon continue et est comparée à une plage de tolérances, et le fait que cette tension quitte la plage de tolérances indique une modification d'accord, caractérisé en ce que la tension de décalage ($U_o$) du neutre est comparée continûment à une valeur de seuil inférieure pouvant être prédéterminée, au-dessous de laquelle des modifications de la tension de décalage du neutre ne peuvent plus être mesurées avec une sensibilité suffisante, mais que, dans le cas d'un dépassement, vers le bas, de la valeur de seuil, la bobine d'extinction d'arc (ZN) est chargée en permanence avec un signal auxiliaire ($I_i$) pour déclencher un accroissement de la tension de décalage ($U_o$) du neutre.

3. Procédé selon la revendication 1 ou 2, utilisé en supplément pour le réglage d'accord manuel ou automatique de la bobine d'extinction d'arc sur un degré de compensation présélectionné, caractérisé en ce que dans le cas de l'identification d'une modification d'accord, la valeur absolue et/ou la phase du signal auxiliaire introduit ($I_i$) sont modifiées d'une manière discrète ou continue, pour déclencher une modification de la tension de décalage ($U_o$), à partir de laquelle le désaccord de la bobine d'extinction d'arc (ZN) est déterminé de façon connue en soi sur la base d'une comparaison complexe de la modification de la tension de décalage du neutre à la modification du signal auxiliaire, à la suite de quoi la bobine d'extinction d'arc est réglée, sur la base du désaccord déterminé, sur le degré de compensation présélectionné.

4. Procédé selon la revendication 3, caractérisé en ce que le signal auxiliaire ($I_i$) est modifié par inversion de la polarité de sa phase.

5. Procédé selon l'une des revendications 1 à 4, caractérisé en ce que la charge de la bobine d'extinction d'arc (ZN) avec le signal auxiliaire ($I_i$) s'effectue par introduction directe d'un courant auxiliaire au niveau du neutre du réseau triphasé.

6. Procédé selon l'une des revendications 1 à 4, caractérisé en ce que la charge de la bobine d'extinction d'arc (ZN) avec le signal auxiliaire ($I_i$) s'effectue par introduction d'un courant auxiliaire dans un enroulement auxiliaire de puissance de la bobine d'extinction d'arc.

*Fig.1*

*Fig.2*

*Fig.3*

*Fig.4*